# EUROPEAN PATENT APPLICATION

(11) **EP 4 779 686 A1**
(43) Date of publication of application: **22.07.2026**
(21) Application number: 24865150.7
(22) Date of filing: 13.08.2024
(51) Int. Cl.: H01L 21/673, G01M 3/26

(54) **PINHOLE AND DEAERATION FAILURE INSPECTION METHOD FOR BAG BODY IN WHICH SEALED STORAGE CONTAINER IS HERMETICALLY PACKAGED, AND PINHOLE AND DEAERATION FAILURE INSPECTION DEVICE FOR BAG BODY IN WHICH SEALED STORAGE CONTAINER IS HERMETICALLY PACKAGED**

(30) Priority: 12.09.2023 JP 2023147294
(71) Applicant: Shin-Etsu Handotai Co., Ltd., Tokyo 100-0004 (JP)
(72) Inventor: MUKAE, Fumikatsu, Nishishirakawa-gun, Fukushima 961-8061 (JP); SATO, Seiji, Annaka-shi, Gunma 379-0196 (JP); SATO, Atsushi, Nishishirakawa-gun, Fukushima 961-8061 (JP)
(74) Representative: Schicker, Silvia
(86) International application number: PCT/JP2024/028939
(87) International publication number: WO 2025/057644

(57) **Abstract**

The present invention is a method for inspecting a pinhole and a degassing failure in a bag body hermetically packaging a sealed storage container, in a state where the sealed storage container storing a semiconductor wafer is hermetically packaged in a degassed state with a resin bag body or an aluminum-vapor-deposited bag body so as to prevent exposure of the sealed storage container to outside air, to inspect presence or absence of the pinhole and presence or absence of the degassing failure in the bag body, the method including the steps of pressurizing, after a predetermined period or longer has elapsed following the hermetic packaging, at least one side surface among side surface portions of the bag body, which hermetically packages the sealed storage container, with a pad, measuring, by employing a sensor provided above an upper end portion of the bag body, which hermetically packages the sealed storage container, a distance between the upper end portion and the sensor in a state pressurized in the step of pressurizing, and determining, based on the distance measured in the step of measuring, the presence or absence of the pinhole and the presence or absence of the degassing failure in the bag body. This provides a method for inspecting, in which a simple method without relying on an inspector enables the determination of the presence or absence of the pinhole and the presence or absence of the degassing failure in the bag body, which hermetically packages the sealed storage container.

## Description

### TECHNICAL FIELD

The present invention relates to a method for inspecting a pinhole and a degassing failure in a bag body hermetically packaging a sealed storage container, and an inspecting apparatus for inspecting a pinhole and a degassing failure in a bag body hermetically packaging a sealed storage container.

### BACKGROUND ART

In recent years, a higher integration and a miniaturization of semiconductor devices have been increasingly advanced, and contamination control of substrates, such as wafers (hereinafter, referred to as "wafer"), including prevention of particle adhesion to the wafers, has become increasingly stringent.

For example, when semiconductor wafers, such as silicon wafers, are transported, the wafers are stored in FOSB (Front Opening Shipping Box) or FOUP (Front Opening Unified Pod), which are sealed storage containers. These sealed storage containers are further hermetically packaged by resin bag bodies or bag bodies further provided with aluminum vapor deposition, and then transported.

The resin bag bodies or bag bodies further provided with aluminum vapor deposition are bags having a moisture-proof function, and are intended to prevent the exposure of the containers to the air containing dust and to prevent condensation from forming on the surface of the semiconductor wafers stored in the sealed storage containers due to the influence of humidity during transportation. Note that various types of hermetic packages are known, and are not limited to those for wafers (Patent Documents 1 to 3).

### CITATION LIST

### PATENT LITERATURE

Patent Document 1: JP 2003-004580 A
Patent Document 2: JP 2015-194362 A
Patent Document 3: JP H11-316169 A

### SUMMARY OF INVENTION

### TECHNICAL PROBLEM

A conventional hermetic package has problems in which a bag body may be accidentally scratched, torn, or punctured during a packaging operation. Furthermore, when holes or tears are large, detection thereof by inspection is relatively easy. However, the detection of a small hole having a diameter of 1 mm or less (hereinafter, may be referred to as a pinhole) by visual inspection has been extremely difficult.

Moreover, for an inspector to inspect the hermetic packaging of a sealed storage container in which semiconductor wafers are stored, the container is lifted by both hands and the hermetic packaging is visually inspected in sequence, with two surfaces on the top and bottom, and four surfaces on the side surfaces. The total weight of FOSB storing 25 wafers having a diameter of 300 mm reaches 8 Kg or more, and thus, this workload has been a physically demanding task for the inspector.

Moreover, the sealed storage container is degassed and hermetically packaged in a state where air between the sealed storage container and a packaging material is elminated as much as possible to minimize the volume of the package during transportation and prevent damage to the packaging material. Accordingly, the inspection can preferably be performed, in combination with a pinhole inspection, to determine whether a degassed state has any issues.

The present invention has been made in view of the above-described problem. An object of the present invention is to provide a method for inspecting that can determine the presence or absence of the pinhole and the presence or absence of the degassing failure in the bag body hermetically packaging the sealed storage container by a simple method without relying on an inspector.

In addition, an object of the present invention is to provide an inspecting apparatus for inspecting that can simply determine presence or absence of a pinhole and presence or absence of a degassing failure in a bag body hermetically packaging a sealed storage container, without relying on an inspector.

### SOLUTION TO PROBLEM

To achieve the object, the present invention provides a method for inspecting a pinhole and a degassing failure in a bag body hermetically packaging a sealed storage container, in a state where the sealed storage container storing a semiconductor wafer is hermetically packaged in a degassed state with a resin bag body or an aluminum-vapor-deposited bag body so as to prevent exposure of the sealed storage container to outside air, to inspect presence or absence of the pinhole and presence or absence of the degassing failure in the bag body, the method comprising the steps of:
pressurizing, after a predetermined period or longer has elapsed following the hermetic packaging, at least one side surface among side surface portions of the bag body, which hermetically packages the sealed storage container, with a pad;
measuring, by employing a sensor provided above an upper end portion of the bag body, which hermetically packages the sealed storage container, a distance between the upper end portion and the sensor in a state pressurized in the step of pressurizing; and
determining, based on the distance measured in the step of measuring, the presence or absence of the pinhole and the presence or absence of the degassing failure in the bag body.

According to such a method for inspecting, by pressurizing the side surface portion of the bag body, when the pinhole is present or when the degassing failure is present, the air between the bag body and the side surface of the sealed storage container is moved to the upper end portion of the bag body, thereby changing the distance between the upper end portion and the sensor. By measuring the distance, the presence or absence of the pinhole and the presence or absence of the degassing failure are determined.

Accordingly, the pinhole inspection of the hermetic package, which has been performed by a worker, can be automatically performed by pressurizing the bag body and then measuring the distance. Unlike conventional inspection, a missed pinhole by the inspector is eliminated; additionally, the degassing failure can also be inspected at the same time, enabling an increase in the number of inspection throughput per time unit and a significant reduction in inspection cost.

In this case, the predetermined period can be 10 minutes.

Accordingly, when the pinhole is present, the bag body can be pressurized after sufficient time has elapsed for air to flow into an interior of the bag body through the pinhole, thereby enabling the improvement of the detecting accuracy of the presence or absence of the pinhole.

In this case,
after the hermetically packaging and before the step of pressurizing, the method further comprises the step of pre-pressurization measuring the distance between the upper end portion and the sensor using the sensor,
in the step of determining, when an amount of displacement, which is a difference between the distance measured in the step of pre-pressurization measuring and the distance measured in the step of measuring, is 1 mm or more, the presence of the pinhole can be determined.

This enables further improvement of the detection accuracy of the presence or absence of the pinhole.

To achieve the object, the present invention provides an inspecting apparatus for inspecting a pinhole and a degassing failure in a bag body hermetically packaging a sealed storage container, in a state where the sealed storage container storing a semiconductor wafer is hermetically packaged in a degassed state with a resin bag body or an aluminum-vapor-deposited bag body so as to prevent exposure of the sealed storage container to outside air, to inspect presence or absence of the pinhole and presence or absence of the degassing failure in the bag body, the inspecting apparatus comprising:
a pad configured to pressurize at least one side surface among side surface portions of the bag body, which hermetically packages the sealed storage container, after a predetermined period or longer has elapsed following the hermetic packaging;
a sensor provided above an upper end portion of the bag body, which hermetically packages the sealed storage container, to measure a distance between the upper end portion and the sensor in a state pressurized by the pad, wherein
based on the distance measured, the presence or absence of the pinhole and the presence or absence of the degassing failure in the bag body are determined.

According to such an inspecting apparatus, by pressurizing the side surface portion of the bag body, when the pinhole is present or when the degassing failure is present, the air between the bag body and the side surface of the sealed storage container is moved to the upper end portion of the bag body, thereby changing the distance between the upper end portion and the sensor. By measuring the distance, the presence or absence of the pinhole and the presence or absence of the degassing failure are determined.

As a result, the pinhole inspection of the hermetic package, which has been performed by a worker, can be automatically performed by pressurizing the bag body and then measuring the distance. Unlike conventional inspection, a missed pinhole by the inspector is eliminated; additionally, the degassing failure can also be inspected at the same time, enabling an increase in the number of inspection throughput per time unit and a significant reduction in inspection cost.

### ADVANTAGEOUS EFFECTS OF INVENTION

As described above, according to the inventive method for inspecting, the presence or absence of the pinhole and the presence or absence of degassing failure in the bag body hermetically packaging the sealed storage container can be determined by a simple method without relying on the inspector.

Moreover, according to the inventive inspecting apparatus, the presence or absence of the pinhole and the presence or absence of degassing failure in the bag body hermetically packaging the sealed storage container can be determined simply without relying on the inspector.

### BRIEF DESCRIPTION OF DRAWINGS

[FIG. 1] is a schematic view illustrating a sealed storage container (FOSB).
[FIG. 2] is a schematic view illustrating a sealed storage container (FOSB) hermetically packaged with a packaging material.
[FIG. 3] is a schematic view of an example in which a distance between an upper end portion of a packaging material hermetically packaging a sealed storage container (FOSB) and a distance-measuring sensor is measured using the sensor.
[FIG. 4] is a schematic view of an example in which a side surface portion of a packaging material hermetically packaging a sealed storage container (FOSB) is pressurized with pressurizing pads, and a distance between an upper end portion of the packaging material hermetically packaging the storage container (FOSB) and a distance-measuring sensor is measured using the sensor.
[FIG. 5] is a schematic view of an example in which a distance between an upper end portion of a packaging material hermetically packaging a sealed storage container (FOSB), in which a pinhole has been formed, and a distance-measuring sensor is measured using the sensor.
[FIG. 6] is a schematic view of an example in which a side surface portion of a packaging material hermetically packaging a sealed storage container (FOSB) is pressurized with pressurizing pads, and a distance between an upper end portion of the packaging material hermetically packaging the storage container (FOSB), in which a pinhole has been formed, and a distance-measuring sensor is measured using the sensor.

### DESCRIPTION OF EMBODIMENTS

Hereinafter, the present invention will be described in detail. However, the present invention is not limited thereto.

As described above, a method for inspecting which enables determination, by a simple method without relying on an inspector, of presence or absence of a pinhole and presence or absence of a degassing failure in a bag body hermetically packaging a sealed storage container has been desired.

To solve the above problem, the present inventors have earnestly studied and found the following method for inspecting a pinhole and a degassing failure in a bag body hermetically packaging a sealed storage container, in a state where the sealed storage container storing a semiconductor wafer is hermetically packaged in a degassed state with a resin bag body or an aluminum-vapor-deposited bag body so as to prevent exposure of the sealed storage container to outside air, to inspect presence or absence of the pinhole and presence or absence of the degassing failure in the bag body. This method includes the steps of: pressurizing, after a predetermined period or longer has elapsed following the hermetic packaging, at least one side surface among side surface portions of the bag body, which hermetically packages the sealed storage container, with a pad; measuring, by employing a sensor provided above an upper end portion of the bag body, which hermetically packages the sealed storage container, a distance between the upper end portion and the sensor in a state pressurized in the step of pressurizing; and determining, based on the distance measured in the step of measuring, the presence or absence of the pinhole and the presence or absence of the degassing failure in the bag body. The present inventors found that, by employing this simple method without relying on an inspector, the presence or absence of the pinhole and the presence or absence of the degassing failure in the bag body hermetically packaging the sealed storage container can be determined. This finding led to the completion of the present invention.

Moreover, as described above, the inspecting apparatus that can determine simply, without relying on an inspector, the presence or absence of the pinhole and the presence or absence of the degassing failure in the bag body hermetically packaging the sealed storage container has been desired.

To solve the above problem, the present inventors have earnestly studied and found the following inspecting apparatus for inspecting a pinhole and a degassing failure in a bag body hermetically packaging a sealed storage container, in a state where the sealed storage container storing a semiconductor wafer is hermetically packaged in a degassed state with a resin bag body or an aluminum-vapor-deposited bag body so as to prevent exposure of the sealed storage container to outside air, to inspect presence or absence of the pinhole and presence or absence of the degassing failure in the bag body. This inspecting apparatus includes: a pad configured to pressurize at least one side surface among side surface portions of the bag body, which hermetically packages the sealed storage container, after a predetermined period or longer has elapsed following the hermetic packaging; a sensor provided above an upper end portion of the bag body, which hermetically packages the sealed storage container, to measure a distance between the upper end portion and the sensor in a state pressurized by the pad, in which based on the distance measured, the presence or absence of the pinhole and the presence or absence of the degassing failure in the bag body are determined. The present inventors found that, by employing this apparatus, the presence or absence of the pinhole and the presence or absence of the degassing failure in the bag body hermetically packaging the sealed storage container can be determined simply without relying on an inspector. This finding led to the completion of the present invention.

Hereinafter, a method for inspecting a pinhole and a degassing failure in a bag body hermetically packaging a sealed storage container and an inspecting apparatus therefor with reference to the drawings according to the embodiment of the present invention will be described.

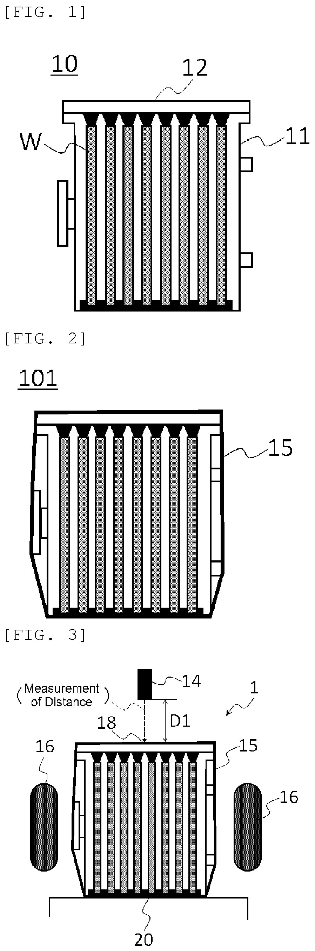

First, a configuration of the sealed storage container hermetically packaged by the bag body that is to be inspected in the present invention will be described with reference to FIG. 1.

As shown in FIG. 1, a sealed storage container (FOSB) 10 is configured with a casing 11 and a lid 12. The casing 11 is a box-shaped member having 1 open side, and is provided with a comb-shaped holding portion for holding a wafer W, which is a semiconductor wafer, on the bottom surface opposite to the open side. The lid 12 is a plate-shaped lid for closing the open side of the casing 11, and includes a lid-side holding portion for holding the wafer W on an inner side of the lid. The sealed storage container 10 typically stores 25 wafers W in the casing 11, and is shipped from a manufacturer of the wafer W in a state where the open side is closed by the lid 12.

### [Packaging]

Next, a hermetically packaged state of the sealed storage container 10 will be described with reference to FIG. 2.

As shown in FIG. 2, the sealed storage container 10 is transported in a state of a packaged body 101 which is packaged with the bag body serving as the packaging material 15 (hereinafter also referred to as a sealed storage container 10 hermetically packaged) in order to accommodate environmental changes such as temperature, atmospheric pressure, and vibration during transportation by airplane, ship, or truck.

This packaging has an effect of preventing condensation on the wafer surface due to changes in temperature and atmospheric pressure, and of preventing contamination, such as an increase in particles caused by outside air entering through a gap between the lid 12 and the casing 11 due to vibration.

As the packaging material 15, a laminated packaging material in which a transparent resin is formed into a sheet shape and then laminated with a layer having a moisture-proof effect, or an aluminum packaging material in which aluminum is vapor-deposited on a surface of a sheet-shaped resin to provide a moisture-proof effect, or the like, is used.

When the sealed storage container 10 is not only shipped but also transported, such transportation is performed in a state where the laminate packaging or aluminum packaging described above, or laminated packaging followed by aluminum packaging, is applied.

Moreover, the packaged body 101 (sealed storage container 10 hermetically packaged) is packaged in a state where the air between the sealed storage container 10 and the packaging material 15 is eliminated as much as possible to prevent exposure of the sealed storage container 10 to the outside air, in order to minimize volume during transportation and prevent damage to the packaging material 15. Specifically, in a state where the sealed storage container 10 is accommodated in the packaging material 15, an interior of the packaging material 15 is depressurized and degassed using a vacuum pump, and then sealed, thereby bringing the sealed storage container 10 hermetically packaged to a hermetic state with air inside the packaging material 15 eliminated as much as possible.

### [Method for Inspecting Pinhole and Degassing Failure]

Next, a method for inspecting a pinhole and a degassing failure in the packaging material 15 for hermetically packaging the sealed storage container 10, and an inspecting apparatus therefor will be described with reference to FIGs. 3 to 6.

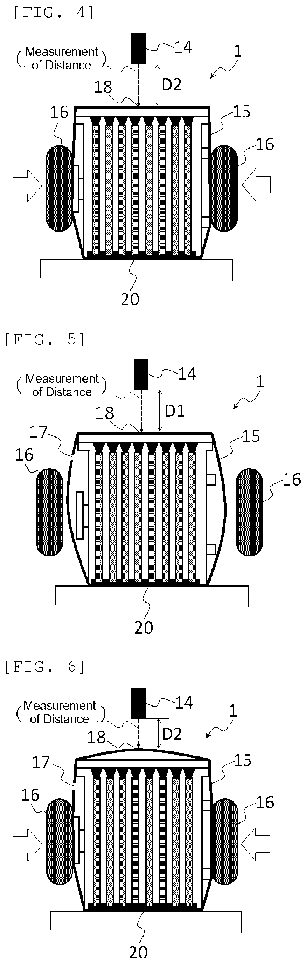

First, a configuration of an inspecting apparatus 1 will be described with reference to FIGs. 3 and 4.

The inspecting apparatus 1 shown in FIG. 3 is an apparatus for inspecting a pinhole and a degassing failure in the packaging material 15 hermetically packaging the sealed storage container 10, and is provided with a pressurizing pad 16 and a distance-measuring sensor 14.

The pressurizing pad 16 is a member for pressurizing the packaging material 15 hermetically packaging the sealed storage container 10 after a predetermined period or longer has elapsed following the hermetically packaging, and is mounted adjacent to the side surface portion of packaging material 15.

FIG. 3 shows a configuration in which a pair of pressurizing pads 16 is arranged adjacent to left and right side surface portions of the packaging material 15 that packages the sealed storage container 10, thereby enabling pressurization of the 2 side surface portions of the packaging material 15. However, the pressurizing pad 16 may only be capable of pressurizing at least one side surface among the side surface portions of the packaging material 15 hermetically packaging the sealed storage container 10. Note that the upper limit of the number of side surface portions to be pressurized is not particularly limited, but when considering top and bottom surface portions may also serve as the side surface portions by changing orientation thereof, for example, the number can be 6 surfaces or less in the case of a cuboid or a cube.

Moreover, a specific pressurizing structure of the pressurizing pad 16 is not particularly limited, but a structure that pressurizes with a gas, such as an airbag, can be exemplified.

The distance-measuring sensor 14 is a sensor arranged above the packaging material 15 hermetically packaging the sealed storage container 10, and is capable of measuring a distance D1 between an upper end portion 18 of the packaging material 15 hermetically packaging the sealed storage container 10 and the sensor 14. In addition, as shown in FIG. 4, in a state where at least one side surface among side surface portions of the packaging material 15 for hermetically packaging is pressurized by the pressurizing pad 16, the sensor 14 can measure a distance D2 between the upper end portion 18 of the packaging material 15 and the sensor 14.

Specific method for detecting the distance by the distance-measuring sensor 14 is not particularly limited, but examples can include the method employing laser or ultrasonic waves.

Next, a procedure of the method for inspecting a pinhole and a degassing failure using the inspecting apparatus 1 will be described with reference to FIGs. 3 to 6.

First, after hermetically packaging the sealed storage container 10 with the packaging material 15 described above, the container 10 is mounted on a support base 20 as shown in FIG. 3, or the like, and kept stationary until a predetermined period or longer has elapsed. The reason is that, in the present invention, the presence or absence of the pinhole is determined by utilizing air that has flowed into between the packaging material 15 and the sealed storage container 10 through the pinhole; however, even when the pinhole is formed, a certain period is needed for air to flow into the interior of the packaging material 15 through the pinhole.

The predetermined period is not particularly limited, but can be, for example, 10 minutes or more. Note that the upper limit of the predetermined period is not particularly limited, but can be, for example, 1 hour or less.

Next, depending on necessity, after the hermetically packaging and before the step of pressurizing described later, as shown in FIG. 3, by employing the distance-measuring sensor 14 provided above the upper end portion 18 of the packaging material 15 hermetically packaging the sealed storage container 10, the distance D1 between the upper end portion 18 of the packaging material 15 hermetically packaging the sealed storage container 10 and the distance-measuring sensor 14 is measured (Step of Pre-pressurization Measuring).

Next, after a predetermined period or longer has elapsed following the hermetic packaging, at least one side surface among the side surface portions of the packaging material 15 hermetically packaging the sealed storage container 10, e.g., a pair of the side surface portions in FIG. 4, is pressurized with the pressurizing pads 16 (Step of Pressurizing).

Next, as shown in FIG. 4, by employing the distance-measuring sensor 14 provided above the upper end portion 18 of the packaging material 15 hermetically packaging the sealed storage container 10, the distance D2 between the upper end portion 18 and the distance-measuring sensor 14 is measured while being pressurized in the step of pressurizing (Step of Measuring).

Here, when no pinhole, which is a hole having a diameter of 1 mm or less, is formed in the packaging material 15, and thus no air flows in through this pinhole and the degassing failure is absent, almost no air is present between the packaging material 15 and the sealed storage container 10. Consequently, as shown in FIG. 4, even when a pair of side surfaces on the left and right sides of the packaging material 15 for packaging the sealed storage container 10 are pressurized, the distance D2 between the upper end portion 18 of the packaging material 15 of the sealed storage container 10 which is packaged and the distance-measuring sensor 14 remains unchanged from the distance D1 before pressurization shown in FIG. 3.

However, as shown in FIG. 5, when a pinhole 17 is present in the packaging material 15, after a predetermined period or longer has elapsed following the packaging of the sealed storage container 10 with the packaging material 15, air flows into a space between the packaging material 15 and the sealed storage container 10. Accordingly, as shown in FIG. 5, air flows into the space between the sealed storage container 10 and the packaging material 15 through the pinhole 17.

In this way, in a state where air has flowed into the space between the sealed storage container 10 and the packaging material 15, the packaging material 15 for hermetically packaging the sealed storage container 10 is pressurized from two sides, on the right and on the left sides, with the pressurizing pads 16. Consequently, the air present between the sealed storage container 10 and the side surface portions of the packaging material 15 is pressurized and moves to the upper end portion 18 of the packaging material 15, thereby pushing up the upper end portion 18 upward.

When the upper end portion 18 is pushed upward, as shown in FIG. 6, the distance D2 between the upper end portion 18 of the packaging material 15 for packaging the sealed storage container 10 and the distance-measuring sensor 14 is changed from the distance D1 before pressurization shown in FIG. 5. Based on the distance D2 measured in this way, it is determined whether the pinhole 17 is present or absent at any position of the packaging material 15 for packaging the sealed storage container 10 (Step of Determining). Specifically, the presence or absence of the pinhole 17 and the presence or absence of the degassing failure can be determined from the amount of displacement, which is the difference between the distance D1 before pressurization and the distance D2 during the pressurization.

Specific degree of the amount of displacement at which the presence of the pinhole may be determined by, for example, comparing the actually measured amount of displacement with the amount of displacement obtained in advance through a preliminary experiment, in which the pinhole is present. For example, when the amount of displacement is 1 mm or more, it can be determined that the pinhole is present. Note that the upper limit of the amount of displacement is not particularly limited, but can be, for example, 10 mm or less.

In the case of a typical inspection using an image captured by, e.g., a camera, in order to inspect the lower surface, or the like, of the sealed storage container 10 which is hermetically packaged, a large-scale holding and rotating mechanism, or the like, is required to inspect the lower (bottom) surface of the sealed storage container 10 which is packaged. However, according to the inventive method, even when the pinhole 17 is present on the lower surface, or the like, of the sealed storage container 10 which is packaged, the possibility that the pinhole 17 is completely blocked by the support base 20 is low. Even when it is blocked, the sealed storage container 10 may be mounted when left standing such that the bottom surface of the sealed storage container 10 in contact with the support base 20 is changed to a surface other than the surface that has been in contact with the support base 20 after a predetermined period has elapsed. Furthermore, by allowing the predetermined period to elapse, and by reducing an area of a support surface 20, which is in contact with the sealed storage container, such an expensive, large-scale, and complicated mechanism is not required. Accordingly, the inspection mechanism in the apparatus for inspecting a pinhole 17 is simplified, thereby enabling the reduction of the size of the apparatus.

Furthermore, by pressurizing 4 surfaces of the side surface portions of the packaging material 15 hermetically packaging the sealed storage container 10 with the pressurizing pad 16, even when an extremely small pinhole 17 is present, it becomes possible to accurately detect the presence or absence of the pinhole 17 from the change in the distance between the upper end portion 18 of the packaging material 15 for the packaged sealed storage container 10 and the distance-measuring sensor 14.

Moreover, as described above, when the sealed storage container 10 is packaged, hermetic packaging is performed in a degassed state. However, when this degassing is insufficient and hermetic packaging is performed without sufficiently eliminating the air between the sealed storage container 10 and the packaging material 15, a degassing failure product is produced. When this degassing failure product is pressurized as in the pinhole inspection, in which the side surface portion of the packaging material 15 for the packaged sealed storage container 10 is pressurized, the air, which is not eliminated during degassing and remains between the sealed storage container 10 and the side surface portions of the packaging material 15, is moved to the upper end portion 18 of the packaging material 15, thereby pushing up the upper end portion 18. Due to the change in the distance D2 between the upper end portion 18 and the distance-measuring sensor 14 from the distance D1, the presence or absence of the degassing failure can be accurately measured.

Furthermore, by configuring a plurality of distance-measuring sensors 14 to be mounted above the upper end portion 18 of the packaging material 15 for the packaged sealed storage container 10, the distance D2, being changed, can be more accurately measured, thereby enabling detection of the extremely small pinhole 17 and the degassing failure caused by trace residual air.

### EXAMPLES

Hereinafter, the present invention will be specifically described with reference to Examples. However, the present invention is not limited thereto.

### (Example 1)

Three sealed storage containers 10 were provided, each storing 25 silicon wafers having a diameter of 300 mm. These sealed storage containers 10 were packaged with an aluminum packaging material serving as a packaging material 15, and then hermetically packaged by sealing the sealed storage containers 10 while degassing.

At 1 location on a side surface of the packaging material 15 for hermetically packaging the sealed storage container 10, a pinhole 17 having a diameter of 1.0 mm was intentionally formed, and each was left to stand for 5 minutes, 10 minutes, and 30 minutes, respectively.

### (Example 2)

As in Example 1, three sealed storage containers 10 were provided, each storing 25 silicon wafers having a diameter of 300 mm. These sealed storage containers 10 were packaged with an aluminum packaging material serving as a packaging material 15, and then hermetically packaged by sealing the sealed storage containers 10 while degassing.

At 1 location on a side surface of the packaging material 15 for hermetically packaging the sealed storage container 10, a pinhole 17 having a diameter of 3.0 mm was intentionally formed, and each was left to stand for 5 minutes, 10 minutes, and 30 minutes, respectively. That is, the diameter of the pinhole 17 was enlarged compared with that in Example 1.

### (Example 3)

As in Example 1, three sealed storage containers 10 were provided, each storing 25 silicon wafers having a diameter of 300 mm. These sealed storage containers 10 were packaged with an aluminum packaging material serving as a packaging material 15, and then hermetically packaged by sealing the sealed storage containers 10 while degassing.

At 1 location on a side surface of the packaging material 15 for hermetically packaging the sealed storage container 10, a pinhole 17 having a diameter of 5.0 mm was intentionally formed, and each was left to stand for 5 minutes, 10 minutes, and 30 minutes, respectively. That is, the diameter of the pinhole 17 was enlarged compared with that in Examples 1 and 2.

### (Example 4)

As in Example 1, three sealed storage containers 10 were provided, each storing 25 silicon wafers having a diameter of 300 mm. These sealed storage containers 10 were packaged with an aluminum packaging material serving as a packaging material 15, and then hermetically packaged by sealing the sealed storage containers 10 while degassing.

No pinhole 17 was formed in packaging material 15 for hermetically packaging the sealed storage container 10, and each was left to stand for 5 minutes, 10 minutes, and 30 minutes, respectively.

### [Pinhole Inspection]

Pinhole inspections were performed on the packaging materials 15 for hermetically packaging the sealed storage containers 10 produced in Examples 1 to 4, according to the inventive method for inspecting. Specifically, left and right surfaces of the packaging materials 15 were pressurized with airbag-type pressurizing pads 16, and distances D1 and D2 between an upper end portion 18 of the packaging material 15 for the packaged sealed storage container 10 and a distance-measuring sensor 14 before and during pressurization were measured, and differences between the distance D1 and the distance D2 were determined as amount of displacements.

Table 1 shows these results.

**[Table 1]**

| | | Example 4 | Example 1 | Example 2 | Example 3 |
|---|---|---|---|---|---|
| | | Pinhole Size (mm) | | | |
| | | 0 | 1.0 | 3.0 | 5.0 |
| Standing Time (minutes) | 5 | 0 | 0.25 | 1.52 | 1. 93 |
| | 10 | 0 | 1.15 | 1.87 | 2.43 |
| | 30 | 0 | 1.74 | 2.41 | 3.14 |
| | | Amount of Displacement(mm) | | | |

As shown in Table 1, Examples 1 to 3, in which the pinholes 17 were formed, exhibited larger amounts of displacement than Example 4, in which the pinhole 17 was not formed. Therefore, the presence of the pinholes 17 in the packaging materials 15 for the sealed storage containers 10 was confirmed from the amounts of displacement.

On the other hand, as shown in Table 1, in Example 1, when the packaged containers were left to stand for 5 minutes, the amount of displacement was 0.25 mm, in contrast to this result, when left to stand for 10 minutes, the amount of displacement was 1.15 mm, and when left to stand for 30 minutes, the amount of displacement was 1.74 mm. Consequently, it was found that in order to obtain the amount of displacement sufficient to determine that the pinhole was open, the packaged container was preferably left to stand for 10 minutes or more.

In Examples 2 and 3, the amount of displacement was 1.0 mm or more in every case where the containers were left to stand for 5, 10, or 30 minutes. This was a sufficient amount of displacement to determine that the pinholes were open.

In addition, in Example 4, the amount of displacement was 0 mm in every case where the containers were left to stand for 5, 10, or 30 minutes, and it was successfully determined that the pinhole was not open.

As described above, according to Examples of the present invention, by employing the pressurizing pad 16 to pressurize at least one surface on the sealed storage container 10 hermetically packaged, and by employing a distance-measuring sensor 14 to measure a distance between the upper end portion 18 of the packaging material 15 for hermetically packaging the sealed storage container 10 and the sensor 14, at least one surface of the sealed storage container 10 was pressurized with pressurizing pad 16. Then, it was found that, when the distance D2 between the upper end portion 18 of the packaging material 15 for the sealed storage container 10 and the sensor 14 was measured, and then a change in the distance D2 compared with the distance D1 before pressurization was found, an inspection to determine whether the pinhole 17 was opened was successfully performed.

Note that in Examples of the present invention, although a case which includes a pair of pressurizing pads 16 and 1 distance-measuring sensor 14 is exemplified, the effect described above is also achievable even when pressurizing with 1 pressurizing pad 16, or 3 or more pressurizing pads 16.

Moreover, although the degassing failure is not exemplified, a degassing failure product can be detected in the same way as in Examples 1 to 3, based on the change (displace amount) in the distance D2 with respect to the distance D1.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for inspecting a pinhole and a degassing failure in a bag body hermetically packaging a sealed storage container, in a state where the sealed storage container storing a semiconductor wafer is hermetically packaged in a degassed state with a resin bag body or an aluminum-vapor-deposited bag body so as to prevent exposure of the sealed storage container to outside air, to inspect presence or absence of the pinhole and presence or absence of the degassing failure in the bag body, the method comprising the steps of:
pressurizing, after a predetermined period or longer has elapsed following the hermetic packaging, at least one side surface among side surface portions of the bag body, which hermetically packages the sealed storage container, with a pad;
measuring, by employing a sensor provided above an upper end portion of the bag body, which hermetically packages the sealed storage container, a distance between the upper end portion and the sensor in a state pressurized in the step of pressurizing; and
determining, based on the distance measured in the step of measuring, the presence or absence of the pinhole and the presence or absence of the degassing failure in the bag body.

2. The method for inspecting a pinhole and a degassing failure in a bag body hermetically packaging a sealed storage container according to Claim 1, wherein
the predetermined period is 10 minutes.

3. The method for inspecting a pinhole and a degassing failure in a bag body hermetically packaging a sealed storage container according to Claim 1 or 2, wherein
after the hermetically packaging and before the step of pressurizing, the method further comprises the step of pre-pressurization measuring the distance between the upper end portion and the sensor using the sensor,
in the step of determining, when an amount of displacement, which is a difference between the distance measured in the step of pre-pressurization measuring and the distance measured in the step of measuring, is 1.0 mm or more, the presence of the pinhole is determined.

4. An inspecting apparatus for inspecting a pinhole and a degassing failure in a bag body hermetically packaging a sealed storage container, in a state where the sealed storage container storing a semiconductor wafer is hermetically packaged in a degassed state with a resin bag body or an aluminum-vapor-deposited bag body so as to prevent exposure of the sealed storage container to outside air, to inspect presence or absence of the pinhole and presence or absence of the degassing failure in the bag body, the inspecting apparatus comprising:
a pad configured to pressurize at least one side surface among side surface portions of the bag body, which hermetically packages the sealed storage container, after a predetermined period or longer has elapsed following the hermetic packaging; and
a sensor provided above an upper end portion of the bag body, which hermetically packages the sealed storage container, to measure a distance between the upper end portion and the sensor in a state pressurized by the pad, wherein
based on the distance measured, the presence or absence of the pinhole and the presence or absence of the degassing failure in the bag body are determined.
